# EUROPEAN PATENT APPLICATION

(11) **EP 2 214 216 A2**
(43) Date of publication of application: **04.08.2010**
(21) Application number: 10152485.8
(22) Date of filing: 03.02.2010
(51) Int. Cl.: H01L 33/00, H01L 21/18

(54) **Semiconductor device and manufacturing method thereof**

(30) Priority: 03.02.2009 TW 98103344
(71) Applicant: Everlight Electronics Co., Ltd., Tucheng 236 T'ai pei (TW)
(72) Inventor: Weng, Ssu-Yuan, Taipei (TW)
(74) Representative: Lippert, Stachow & Partner

(57) **Abstract**

A method for manufacturing a semiconductor device is provided. The method includes steps of forming a semiconductor element layer (32) on a first substrate (31); bonding a second substrate (33) to the semiconductor element layer (32); and replacing the first substrate (31) with a combining substrate (45), wherein the combining substrate (45) has a thermal conductivity larger than that of the first substrate (31).

## Description

The present invention relates to a semiconductor device and the manufacturing method thereof, and more particularly to a film light emitting diode device and the manufacturing method thereof.

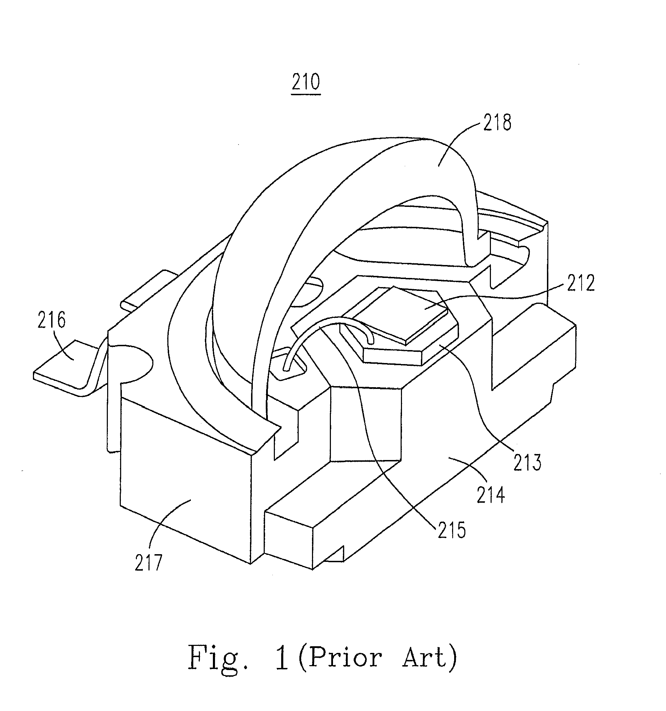

Please refer to Fig. 1, which shows the structure of a conventional light emitting diode device. As shown in Fig. 1, the light emitting diode device 210 includes a light emitting diode element 212, a silicon substrate 213, a radiator 214, a conducting wire 215, a lead 216, a packaging housing 217 and a lens 218. The conducting wire 215 can be a gold wire. The structure of the light emitting diode device 210 can be, for example, the thin film flip chip (TFFC) structure of K2 product of Philips Lumileds. The light emitting diode element 212 includes a thin film p-n heterojunction made of GaN.

The method for manufacturing the light emitting diode device 210 includes the following steps: forming the light emitting diode element 212 on a sapphire substrate (not shown); inverting the sapphire substrate and the light emitting diode element 212 to form a flip chip state; combining the silicon substrate 213 with the light emitting diode element 212; combining the radiator 214 with the silicon substrate 213; removing the sapphire substrate; forming the lead 216 and the packaging housing 217 beside the radiator 214; connecting the silicon substrate 213 with the lead 216 by the conducting wire 215; and forming the lens 218 on the radiator 214 and the packaging housing 217 to cover the conducting wire 215, the light emitting diode element 212 and the silicon substrate 213.

The thermal conductivity of the sapphire substrate is about 35 W/(mK). Even if the thickness of the sapphire substrate is reduced to 100 microns, it is also hard to obtain the ideal heat-dissipating efficiency thereof. For increasing the heat-dissipating efficiency and brightness of the light emitting diode device 210, in the above-mentioned steps, the laser beam can be used to remove the sapphire substrate from the light emitting diode element 212. However, since such conventional laser lift-off technique will reduce the yield stress of the light emitting diode element 212, a structural break will be easily generated in the light emitting diode element 212.

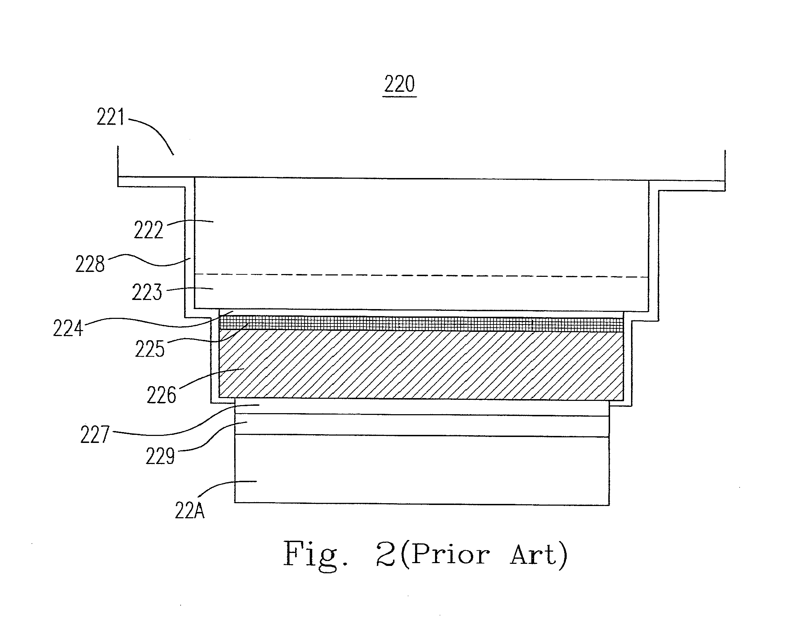

Please refer to Fig. 2, which shows the structure of another conventional light emitting diode device. As shown in Fig. 2, the light emitting diode device 220 includes a SiC substrate 221, an N-type GaN layer 222, a P-type GaN layer 223, a P-type contact layer 224, a reflecting layer 225, a TiW stopper layer 226, a Ti metal layer 227, a SiN passivation layer 228, a Ni metal layer 229 and a contact metal layer 22A. The material of the contact metal layer 22A can be a Au-Sn alloy, Au or Sn. The structure of the light emitting diode device 220 can be, for example, the XT chip structure of Cree corporation.

The N-type GaN layer 222 and the P-type GaN layer 223 are sequentially formed beneath the SiC substrate 221 by epitaxy. The P-type contact layer 224, the reflecting layer 225, the TiW stopper layer 226 and the Ti metal layer 227 are sequentially formed beneath the P-type GaN layer 223. The SiN passivation layer 228 covers the N-type GaN layer 222, the P-type GaN layer 223, the P-type contact layer 224, the reflecting layer 225 and the TiW stopper layer 226 at their laterals.

The Ni metal layer 229 and the contact metal layer 22A are sequentially formed beneath the Ti metal layer 227. The light emitting diode device 220 can further include a lead frame (not shown). The lead frame is combined with the contact metal layer 22A by eutectic attaching through heating and using a flux.

Since the SiC substrate 21 of the light emitting diode device 220 is not removed, the heat-dissipating efficiency and brightness thereof will be affected.

For increasing the heat-dissipating efficiency and brightness of the light emitting diode device 220 and effectively reducing the structural break generated in the light emitting diode element 212, a more effective method for manufacturing the semiconductor device is required.

In order to overcome the drawbacks in the prior art, a semiconductor device and the manufacturing method thereof are provided. The particular design in the present invention not only solves the problems described above, but also is easy to be implemented. Thus, the present invention has the utility for the industry.

In accordance with one aspect of the present invention, a semiconductor device and the manufacturing method thereof are provided. The present invention die-bonds the thin film chip by using a bonding glue, eutectic attaching and a substrate transferring method, and then a normal wire bonding process is performed, which overcomes the issues that the original substrate itself will absorb light and has a poor thermal conductivity.

In accordance with another aspect of the present invention, a method for manufacturing a semiconductor device is provided. The method includes steps of forming a semiconductor element layer on a first substrate; bonding a second substrate to the semiconductor element layer; and replacing the first substrate with a combining substrate, wherein the combining substrate has a thermal conductivity larger than that of the first substrate.

In accordance with a further aspect of the present invention, a method for manufacturing a semiconductor device is provided. The method includes steps of forming a semiconductor element on a first substrate; bonding a second substrate to the semiconductor element; and replacing the first substrate with a combining substrate, wherein the combining substrate has a thermal conductivity larger than that of the first substrate.

In accordance with further another aspect of the present invention, a semiconductor device is provided. The semiconductor device includes a first surface and a second surface, wherein the first surface and the second surface both radiate light and are opposite to each other; a third surface firstly combined with an original first substrate, which is to be removed eventually; a fourth surface combined with a temporary substrate for facilitating a removal of the original first substrate; and a fifth surface combined with a combining substrate for facilitating a removal of the temporary substrate, wherein the second surface is the fourth surface, and the first surface is the third surface and the fifth surface.

In accordance with further another aspect of the present invention, a semiconductor device is provided. The semiconductor device includes a first surface firstly combined with an original first substrate, which is to be removed eventually; a second surface opposite to the first surface; a third surface combined with a temporary substrate for facilitating a removal of the original first substrate; and a fourth substrate combined with a combining substrate for facilitating a removal of the temporary substrate, wherein the first surface is the fourth surface, and the second surface is the third surface.

The above objects and advantages of the present invention will become more readily apparent to those ordinarily skilled in the art after reviewing the following detailed descriptions and accompanying drawings, in which:

Fig. 1 shows the structure of a conventional light emitting diode device;

Fig. 2 shows the structure of another conventional light emitting diode device; and

Figs. 3(a)-3(l) show the configurations of the semiconductor device in the present invention.

The present invention will now be described more specifically with reference to the following embodiments. It is to be noted that the following descriptions of preferred embodiments of this invention are presented herein for the purposes of illustration and description only; it is not intended to be exhaustive or to be limited to the precise form disclosed.

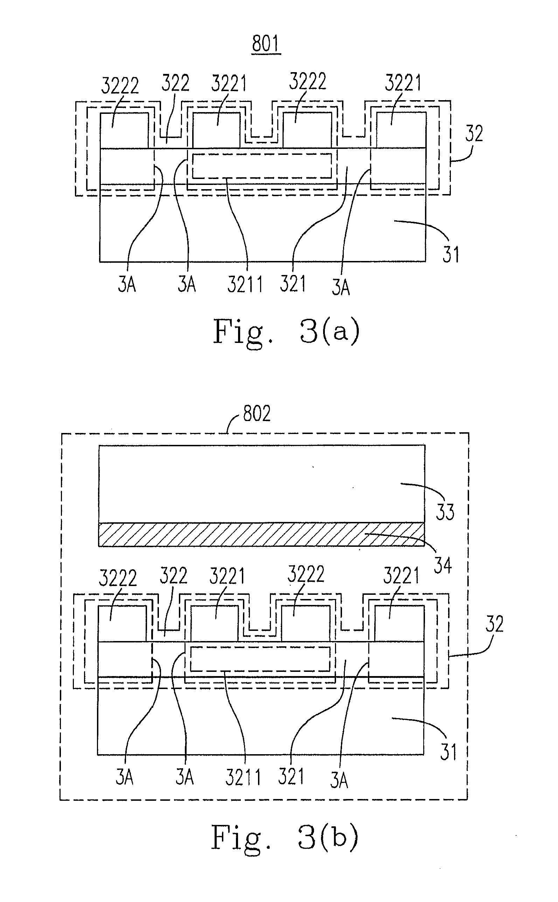

Figs. 3(a)-3(l) show the configurations of the semiconductor device in the present invention. As shown in Fig. 3(a), the semiconductor device 801 includes a substrate 31 and a semiconductor element layer 32 formed on the substrate 31. The semiconductor element layer 32 includes an element main body layer 321 formed on the substrate 31 and a contact layer 322 formed on the element main body layer 321. The contact layer 322 includes at least two contacts 3221, 3222.

The semiconductor element layer 32 includes at least one semiconductor element 3A. The semiconductor element 3A includes a portion 3211 of the element main body layer 321 and the contacts 3221, 3222. The semiconductor element 3A can be a light emitting diode element, e.g. the light emitting diode element 212 in Fig. 1. When the semiconductor element 3A is a light emitting diode element, the substrate 31 can be a sapphire substrate, the contact 3221 can be a P-type contact, the contact 3222 can be an N-type contact, and the forming method for the element main body layer 321 can include an epitaxy growth method.

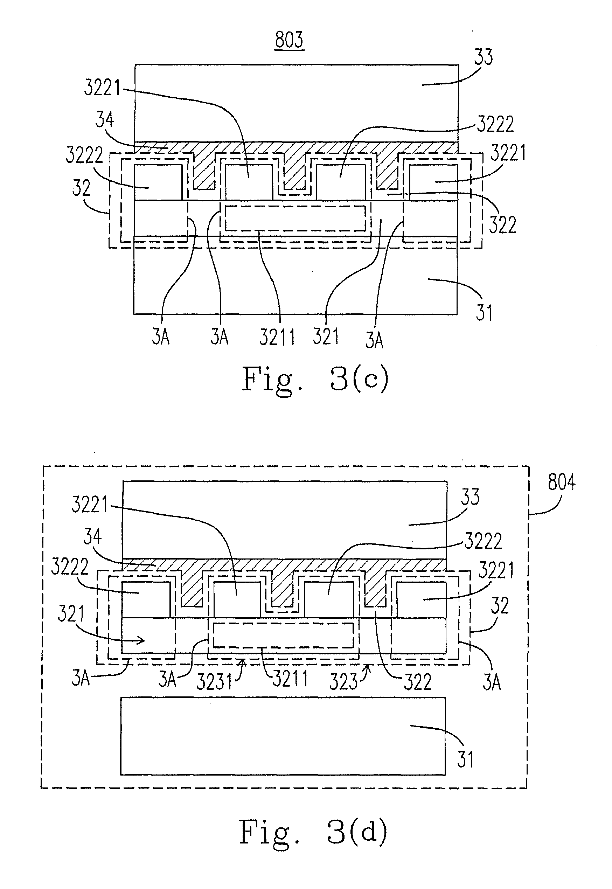

Figs. 3(b) and 3(c) show the configurations 802, 803 of the semiconductor device in the present invention respectively. As shown in Figs. 3(b) and 3(c), a substrate 33 is bonded to the semiconductor element layer 32. In one embodiment, a bonding glue 34 is formed between the semiconductor element layer 32 and the substrate 33 to bond the semiconductor element layer 32 and the substrate 33 together, wherein the bonding glue 34 is peeled by a first radiation. In one embodiment, the first radiation can be a thermal radiation or an electromagnetic wave radiation. In another embodiment, the first radiation can be an ultraviolet, and accordingly the bonding glue 34 can be an ultraviolet-sensitive glue.

In Fig. 3(b), the bonding glue 34 is firstly applied to the substrate 33, and then in Fig. 3(c), the substrate 33 is bonded to the semiconductor element layer 32 with the bonding glue 34. In another embodiment, the bonding glue 34 is firstly applied to the semiconductor element layer 32, and then the substrate 33 is bonded to the semiconductor element layer 32 with the bonding glue 34.

Figs. 3(d)-3(g) show the configurations 804, 805, 806, 807 of the semiconductor device in the present invention respectively. As shown in Figs. 3(d)-3(g), for overcoming the issues that the substrate 31 itself will absorb light and has poor thermal conductivity, the substrate 31 is replaced with a combining substrate 35. The thermal conductivity of the combining substrate 35 is larger than that of the substrate 31. Firstly, the substrate 31 is removed from the semiconductor element layer 32, and then the combining substrate 35 is formed beneath the semiconductor element layer 32.

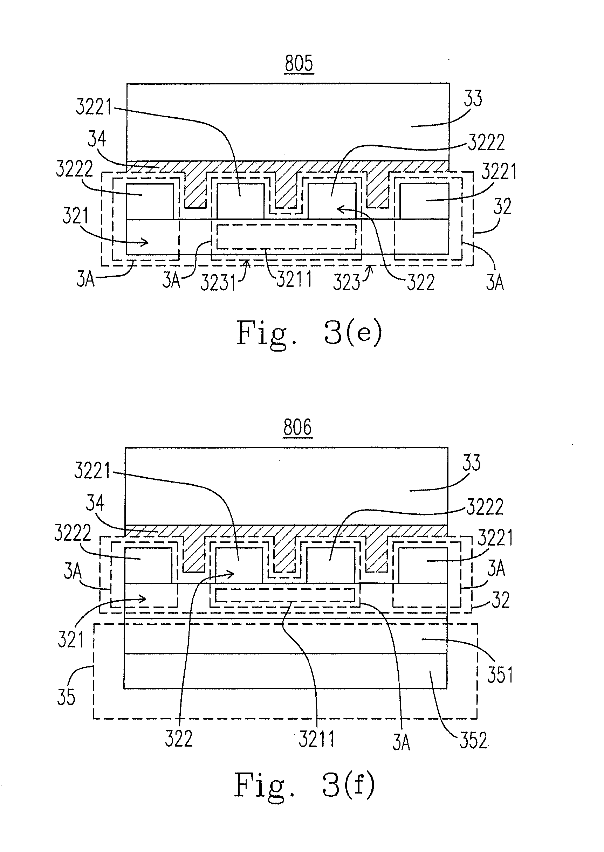

In Fig. 3(d), the substrate 31 is removed from the semiconductor element layer 32, thereby forming the configuration 805 of the semiconductor device in Fig. 3(e). In one embodiment, the substrate 31 is grinded to be removed from the semiconductor element layer 32. In another embodiment, the ultraviolet is used to irradiate the substrate 31 to remove it from the semiconductor element layer 32. Due to the removal of the substrate 31, in the configurations 804, 805 of the semiconductor device, the semiconductor element layer 32 has a surface 323 and the semiconductor element 3A has a surface 3231, wherein the surface 3231 is a portion of the surface 323.

In Fig. 3(f), the combining substrate 35 of the configuration 806 of the semiconductor device includes a structure layer 351 and a metal layer 352. The structure layer 351 is formed beneath the semiconductor element layer 32; that is, the structure layer 351 is formed beneath the surface 323. Besides, the metal layer 352 is formed beneath the structure layer 351. The structure layer 351 can include the reflecting layer 225, the TiW stopper layer 226, the Ti metal layer 227 and the Ni metal layer 229 as shown in Fig. 2. In one embodiment, the metal layer 352 is deposited by evaporation.

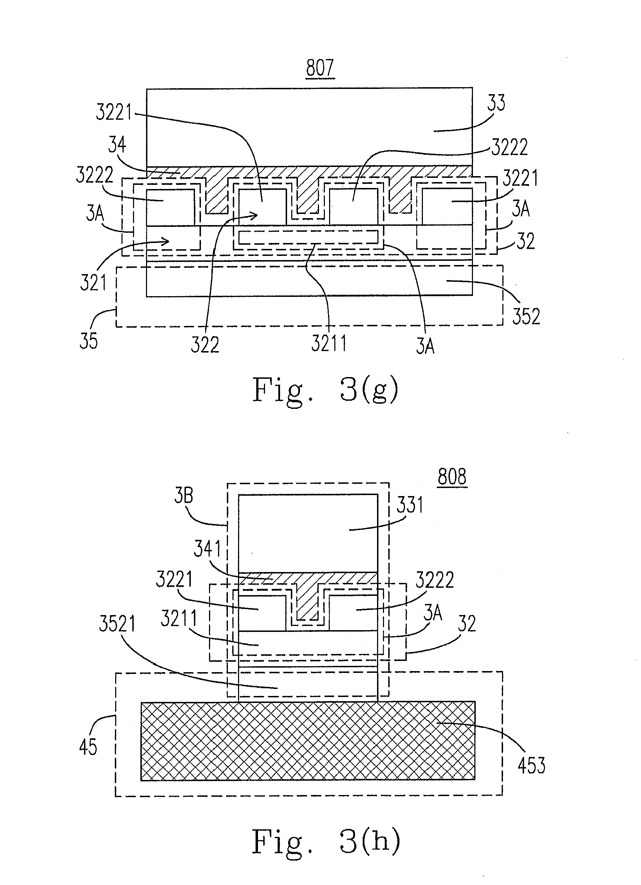

In Fig. 3(g), the combining substrate 35 of the configuration 807 of the semiconductor device includes a metal layer 352. Through deposition, the metal layer 352 can be formed beneath the semiconductor element layer 32. The material of the metal layer 352 can be Au-Sn alloy, Sn-Cu alloy or Sn.

Fig. 3(h) shows the configuration 808 of the semiconductor device in the present invention. As shown in Fig. 3(h), the configuration 808 of the semiconductor device includes a chip unit 3B and a holder 453. The chip unit 3B is formed by cutting the substrate 33 of the configuration 807 of the semiconductor device, the bonding glue 34, the semiconductor element layer 32 and the metal layer 352 in Fig. 3(g). The chip unit 3B includes a portion 331 of the substrate 33, a portion 341 of the bonding glue 34, the semiconductor element 3A and a portion 3521 of the metal layer 352.

The holder 453 is attached to the portion 3521 of the metal layer 352 of the chip unit 3B by eutectic attaching. In one embodiment, the metal layer 352 is combined with the holder 453 by eutectic attaching through heating and using a flux. The configuration 808 of the semiconductor device includes a combining substrate 45. The combining substrate 45 includes the portion 3521 of the metal layer 352 and the holder 453, wherein the thermal conductivity of the combining substrate 45 is larger than that of the substrate 31.

In one embodiment, the holder 453 can include a radiator (not shown). The radiator is attached to the portion 3521 of the metal layer 352 by eutectic attaching. Through the heat dissipating by the combining substrate 45, the issues that the substrate 31 itself will absorb light or has poor thermal conductivity can be overcome.

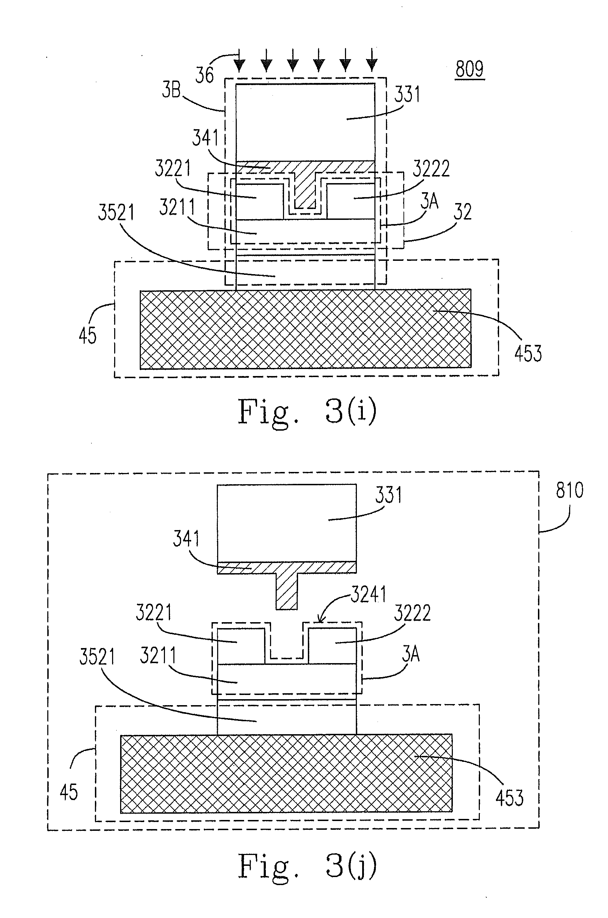

Figs. 3(i) and 3(j) show the configurations 809, 810 of the semiconductor device in the present invention respectively. As shown in Figs. 3(i) and 3(j), the portion 331 of the substrate 33 and the portion 341 of the bonding glue 34 are removed from the semiconductor element layer 32. In one embodiment, the portion 331 of the substrate 33 and the portion 341 of the bonding glue 34 are removed by a radiation 36. In one condition, the adhesion of the portion 341 of the bonding glue 34 is reduced by the radiation 36 so that the portion 331 of the substrate 33 and the portion 341 of the bonding glue 34 are detached.

In one embodiment, the radiation 36 is an ultraviolet, and the substrate 33 is transparent to the ultraviolet. Preferably, the frequency of the ultraviolet is less than 410 nm. Due to the removal of the portion 331 of the substrate 33 and the portion 341 of the boding glue 34, in the configuration 810 of the semiconductor device, the semiconductor element 3A has a surface 3241.

From the descriptions of Figs. 3(g)-3(j), the following embodiment can be easily understood. In Fig. 3(g), the combining substrate 35 of the configuration 807 of the semiconductor device can include a metal layer 352 and a holder (not shown). The holder is formed beneath the metal layer 352. Besides, under the support of the combining substrate 35, the substrate 33 can be removed.

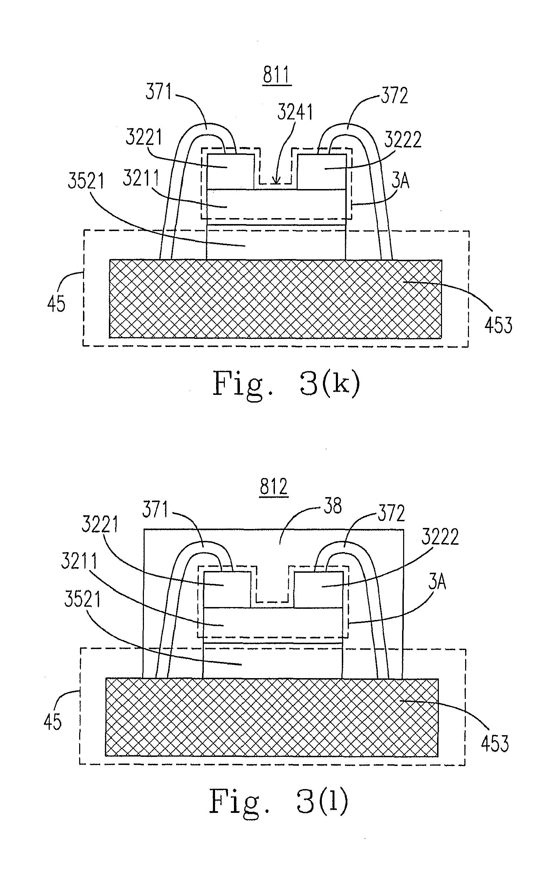

Fig. 3(k) shows the configuration 811 of the semiconductor device in the present invention. In Fig. 3(k), at least one conducting wire is used to electrically connect the semiconductor element 3A with the holder 453. As shown in Fig. 3(k), the configuration 811 of the semiconductor device includes the semiconductor element 3A, the combining substrate 45 and conducting wires 371, 372. The semiconductor element 3A includes the portion 3211 of the element main body layer 321 and the contacts 3221, 3222. The combining substrate 45 includes the portion 3521 of the metal layer 352 and the holder 453.

When the semiconductor element 3A is a light emitting diode element, the contact 3221 can be a P-type contact and the contact 3222 can be an N-type contact. The conducting wires 371, 372 can be made of Au. The conducting wire 371 is electrically connected to the contact 3221 and a first conducting wire (not shown) of the holder 453. Besides, the conducting wire 372 is electrically connected to the contact 3222 and a second conducting wire (not shown) of the holder 453.

Fig. 3(l) shows the configuration 812 of the semiconductor device in the present invention. The configuration 812 of the semiconductor device includes the configuration 811 of the semiconductor device with a packaging housing. As shown in Fig. 3(l), on the holder 453, a molding material 38 is used to cover the conducting wires 371, 372, the semiconductor element 3A and the portion 3521 of the metal layer 352.

Please refer to Figs. 3(a), 3(c) and 3(g), which illustrate the method for manufacturing the semiconductor device in the present invention. The method includes steps of forming the semiconductor element 3A on the substrate 31, bonding the substrate 33 to the semiconductor element 3A; and replacing the substrate 31 with the combining substrate 35, wherein the thermal conductivity of the combining substrate 35 is larger than that of the substrate 31.

Please refer to Figs. 3(a)-3(j), which illustrate the semiconductor device of the present invention. The semiconductor device includes the semiconductor element 3A. The semiconductor element 3A includes the surfaces 3231, 3241, wherein the surfaces 3231, 3241 both radiate light and are opposite to each other. The surface 3231 is firstly combined with the original substrate 31, which is to be removed eventually. Moreover, the surface 3231 is combined with the combining substrate 45 for facilitating the removal of the portion 331 of the temporary substrate 33. The surface 3241 is combined with the temporary substrate 33 for facilitating the removal of the original substrate 31.

In another embodiment of the semiconductor device, the semiconductor device includes the semiconductor element 3A. The semiconductor element 3A includes the surfaces 3231, 3241, wherein the surface 3241 is opposite to the surface 3231. The surface 3231 is firstly combined with the original substrate 31, which is to be removed eventually. Besides, the surface 3231 is combined with the combining substrate 45 for facilitating the removal of the portion 331 of the temporary substrate 33. The surface 3241 is combined with the temporary substrate 33 for facilitating the removal of the original substrate 31. Moreover, the surface 323 of the semiconductor element layer 32 can be combined with the combining substrate 35 for facilitating the removal of the temporary substrate 33.

Based on the above, the present invention effectively solves the problems and drawbacks in the prior art, and thus it fits the demand of the industry and is industrially valuable.

## Claims

1. A method for manufacturing a semiconductor device, **characterized by** comprising steps of:
(a) forming a semiconductor element layer (32) on a first substrate (31);
(b) bonding a second substrate (33) to the semiconductor element layer (32); and
(c) replacing the first substrate (31) with a combining substrate (45) ,
wherein the combining substrate (45) has a thermal conductivity larger than that of the first substrate (31).

2. A method as claimed in Claim 1, **characterized in that** the step (c) comprises steps of:
(d) removing the first substrate (31);
(e) forming the combining substrate (35) beneath the semiconductor element layer (32); and
(f) removing the second substrate (33).

3. A method as claimed in Claim 2, **characterized in that** the step (d) comprises a sub-step of:
removing the first substrate by grinding (31).

4. A method as claimed in Claim 2, **characterized in that** the step (d) comprises a sub-step
of:
using an ultraviolet to irradiate the first substrate (31) so as to remove the first substrate (31).

5. A method as claimed in Claim 2, **characterized in that** the combining substrate (35) comprises a metal layer (352), and the step (e) comprises a sub-step of:
forming the metal layer (352) beneath the semiconductor element layer (32).

6. A method as claimed in Claim 5, **characterized by** further comprising a step of:
forming the metal layer (352) by evaporation.

7. A method as claimed in Claim 2, **characterized in that** the combining substrate (35) comprises a structure layer (351) and a metal layer (352), and the step (e) comprises sub-steps of:
forming the structure layer (351) beneath the semiconductor element layer (32); and
forming the metal layer (352) beneath the structure layer (351).

8. A method as claimed in Claim 2, **characterized in that** the step (f) comprises a sub-step of:
using an ultraviolet to irradiate the second substrate (33) so as to remove the second substrate (33).

9. A method as claimed in Claim 1, **characterized in that**:
the semiconductor element layer (32) comprises a semiconductor element (3A);
the combining substrate (45)comprises a metal layer (352) and a holder (453) having a conducting wire;
the step (b) comprises a step of:
forming a bonding glue (34) between the semiconductor element layer (32) and the second substrate (33) to bond the semiconductor element layer (32) to the second substrate (33), wherein the bonding glue (34) is peeled by a first radiation (36); and
the step (c) comprises steps of:
removing the first substrate (31);
forming the metal layer (352) beneath the semiconductor element layer (32);
cutting the second substrate (33), the bonding glue (34), the semiconductor element layer (32) and the metal layer (352) to form a chip unit (3B), wherein the chip unit (3B) comprises a portion of the second substrate (331), a portion of the bonding glue (341), the semiconductor element (3A) and a portion of the metal layer (3521);
attaching the holder (453) to the portion of the metal layer (3521) by an eutectic attaching;
using a second radiation (36) to remove the portion of the second substrate (331) and the portion of the glue (341);
using at least one main conducting wire (371, 372) to electrically connect the semiconductor element (3A) with the holder (453); and
covering the at least one main conducting wire (371, 372), the semiconductor element (3A) and the portion of the metal layer (3521) on the holder (453) by using a molding material (38).

10. A method as claimed in Claim 9, **characterized in that**:
the semiconductor element (3A) is a light emitting diode element having a P-type contact and an N-type contact;
the main conducting wire (371, 372) electrically connects one of the P-type contact (3221) and the N-type contact (3222) with the conducting wire (371, 372) of the holder (453);
the bonding glue (34) is an ultraviolet-sensitive glue;
the second radiation (36) is an ultraviolet having a wavelength less than 410 nm;
the second substrate is transparent to the ultraviolet;
the portion of the bonding glue (341) has an adhesion reduced by the second radiation (36) so that the portion of the second substrate (331) and the portion of the bonding glue (341) are detached; and
the step (c) further comprises a sub-step of:
combining the metal layer (352) with the holder (453) by heating and using a flux.

11. A method for manufacturing a semiconductor device, **characterized by** comprising steps of:
forming a semiconductor element (3A) on a first substrate (31);
bonding a second substrate (33) to the semiconductor element (3A); and
replacing the first substrate (31) with a combining substrate (45), wherein the combining substrate (45) has a thermal conductivity larger than that of the first substrate (31).

12. A method as claimed in Claim 11, **characterized by** further comprising steps of:
forming a bonding glue (34) between the semiconductor element (3A) and the second substrate (33) to bond the semiconductor element (3A) to the second substrate (33);
removing the first substrate (31);
forming a metal layer of the combining substrate (45) beneath the semiconductor element (3A);
attaching a holder (453) of the combining substrate (45) to the metal layer by an eutectic attaching;
removing the second substrate (33);
removing a portion of the second substrate (331)and a portion of the bonding glue (341) having an adhesion by using an radiation (36), wherein the radiation (36) reduces the adhesion to the semiconductor element (3A) and the second substrate (33);
using at least one conducting wire (371, 372) to electrically connect the semiconductor element (3A) with the holder (453); and
covering the at least one conducting wire (371, 372) and the semiconductor element (3A) on the holder (453) by using a molding material (38).

13. A semiconductor device, **characterized by** comprising:
a first surface (3231) and a second surface (3241), wherein the first surface (3231) and the second surface (3241) both radiate light and are opposite to each other;
a third surface (3231) firstly combined with an original first substrate (31), which is to be removed eventually;
a fourth surface (3241) combined with a temporary substrate (33) for facilitating a removal of the original first substrate (31); and
a fifth surface (3231) combined with a combining substrate (35) for facilitating a removal of the temporary substrate (33), wherein the second surface (3241) is the fourth surface (3241), and the first surface (3231) is the third surface (3231) and the fifth surface (3231).

14. A semiconductor device, **characterized by** comprising:
a first surface (3231) firstly combined with an original first substrate (31), which is to be removed eventually;
a second surface (3241) opposite to the first surface (3231);
a third surface (3241) combined with a temporary substrate (33) for facilitating a removal of the original first substrate (31); and
a fourth substrate (3231) combined with a combining substrate (45) for facilitating a removal of the temporary substrate (33), wherein the first surface (3231) is the fourth surface (3231), and the second surface (3241) is the third surface (3241).

15. A semiconductor device as claimed in Claim 14, **characterized in that** the semiconductor device is a light emitting diode element.

16. A semiconductor device as claimed in Claim 15, **characterized in that** the third surface (3241) is combined with the temporary substrate (33) by using a bonding glue (34).

17. A semiconductor device as claimed in Claim 16, **characterized in that** the bonding glue (34) is peeled by a first radiation (36) so as to remove the temporary substrate (33).

18. A semiconductor device as claimed in Claim 13, **characterized in that** the combining substrate (45) comprises:
a structure layer (351) formed beneath the fourth surface (3231);
a metal layer (352) formed beneath the structure layer (351); and
a holder (453) formed beneath the metal layer (352).

19. A semiconductor device as claimed in Claim 13, **characterized in that** the combining substrate (45) comprises:
a metal layer (352) formed beneath the fourth surface (3231) by an evaporation; and
a holder (453) combined with the metal layer (352) by an eutectic attaching through heating and using a flux.

20. A semiconductor device as claimed in Claim 19, **characterized in that** the metal layer (352) is made of one selected from a group consisting of Au-Sn alloy, Sn-Cu alloy and Sn.
